# EUROPEAN PATENT APPLICATION

(11) **EP 4 741 658 A1**
(43) Date of publication of application: **13.05.2026**
(21) Application number: 24836394.7
(22) Date of filing: 08.07.2024
(51) Int. Cl.: F04B 49/00, F04B 49/03, F04B 37/14, H01L 21/67

(54) **VACUUM PUMP SYSTEM AND CONTROL METHOD THEREFOR**

(30) Priority: 06.07.2023 KR 20230087466; 04.09.2023 KR 20230116769
(71) Applicant: LOT Vacuum Co., Ltd., Osan-si, Gyeonggi-do 18102 (KR)
(72) Inventor: LEE, Keun Young, Seoul 07391 (KR); HONG, Dong Wan, Seoul 08288 (KR); SHIN, Ji Hoon, Hwaseong-si Gyeonggi-do 18372 (KR)
(74) Representative: Regimbeau
(86) International application number: PCT/KR2024/009718
(87) International publication number: WO 2025/009947

(57) **Abstract**

A vacuum pump system and a control method therefor according to the present invention include: a process chamber in which a deposition process is performed; a dry pump connected to the process chamber and converting an atmospheric state of the process chamber into a vacuum state; a first booster pump connecting the process chamber with the dry pump and assisting an operation of the dry pump; a gate valve provided between the process chamber and the first booster pump; a valve controller that controls opening/closing of the gate valve; and a pump controller connected to the valve controller and controlling the operations of the dry pump and the first booster pump in accordance with an opening signal input from the valve controller to the gate valve, wherein the pump controller may stop the operation of the first booster pump when the opening signal is input from the valve controller to the gate valve during the operation of the dry pump.

## Description

### [Technical Field]

The present invention relates to a vacuum pump system and a method of controlling the same, and more specifically, to a vacuum pump system in which a dry pump is prevented from being stopped by minimizing the inflow of a large amount of process byproducts, which is accumulated in a vacuum pipe between a process chamber and a gate valve, through the dry pump and minimizing an overload applied to the dry pump, and a method of controlling the same.

### [Background Art]

Generally, various processes, such as photo processes, diffusion processes, etching processes, thin film deposition processes, etc., are repeatedly performed on wafters to fabricate chips which are semiconductor devices. Among the processes, a thin film deposition process is a process of forming a thin film on a wafer and is performed by a physical vapor deposition method or a chemical vapor deposition (CVD) method according to a thin film deposition method, and recently, the CVD method, in which a compound in a gaseous state is decomposed and a chemical reaction occurs to form a thin film on a wafer, has been widely used.

The CVD method is a gas reaction process method generally used in a semiconductor industry to deposit a thin layer of a material on a surface of an integrated circuit substrate.

In order to perform the CVD method, there are a process chamber in which a process is performed, a dry pump (DP) for converting an atmospheric state of the process chamber to a vacuum state, a booster pump (BP) for assisting operation of the DP, and an auto gate valve (AGV) which is disposed between the process chamber and the booster pump and allows or blocks a flow of air flowing toward the DP.

When the AGV is opened while the process is performed, the BP operates, and a large amount of process byproducts, which is accumulated in a vacuum pipe disposed between and connected to the process chamber and the gate valve and is greater than a processable amount of the DP, is introduced into the DP.

In this case, it is required to discharge the process byproducts, which are introduced into the DP, from the DP.

Meanwhile, while discharging the process byproducts, a load of the DP is rapidly increased.

When the load of the DP is increased, an overload alarm may occur to stop the operation of the DP. As described above, when the operation of the DP is stopped, since the semiconductor deposition process is not performed properly, there is a problem of reducing a manufacturing efficiency for a semiconductor wafer.

### [Detailed Description of Invention]

### [Technical Problem]

The purpose of the present invention is directed to providing a vacuum pump system in which the inflow of process byproducts into a dry pump may be minimized even when a gate valve is opened while a process is performed, and a method of controlling the same.

Objectives to be achieved by the present invention are not limited to the above-described objectives, and other objectives, which are not described above, may be clearly understood by those skilled in the art through the following specification.

### [Technical Solution]

According to the present invention, the above-described objective may be achieved from a vacuum pump system which includes a process chamber in which a deposition process is performed, a dry pump which is connected to the process chamber and converts an atmospheric state of the process chamber to a vacuum state, a first booster pump which connects the process chamber and the dry pump and assists operation of the dry pump, a gate valve provided between the process chamber and the first booster pump, a valve controller which controls the gate valve to be opened or closed, and a pump controller which is connected to the valve controller and controls the dry pump and the first booster pump to operate according to an opening signal input to the gate valve from the valve controller, wherein when the opening signal is input to the gate valve from the valve controller while the dry pump operates, the pump controller stops the operation of the first booster pump.

The gate valve may be opened after the opening signal is input and a preset buffer delay time elapses.

The pump controller may stop the operation of the first booster pump during the buffer delay time of the gate valve.

The gate valve may be opened after the operation of the first booster pump is stopped.

The vacuum pump system may further include a second booster pump which assists the operation of the first booster pump, wherein the second booster pump may connect the process chamber and the first booster pump, and the second booster pump may be controlled to be operated by the pump controller.

One or more of a rated capacity or a rated speed of the second booster pump may be provided to be different from those of the first booster pump.

When the opening signal is input to the gate valve from the valve controller, the pump controller may sequentially stop the second booster pump and the first booster pump.

The pump controller may sequentially decelerate the second booster pump and the first booster pump and then stop the second booster pump and the first booster pump when the opening signal is input to the gate valve from the valve controller.

After the operation of the second booster pump and the first booster pump is stopped, the gate valve may be opened.

The pump controller may start the first booster pump and the second booster pump at rated speeds after the gate valve is opened.

The pump controller may sequentially start the first booster pump and the second booster pump.

The pump controller may sequentially accelerate the first booster pump and the second booster pump.

Meanwhile, according to another embodiment of the present invention, the above-described objectives may be achieved from a method of controlling the above-described vacuum pump system, which includes operation (a) of starting a dry pump, operation (b) of inputting an opening signal to a gate valve, operation (d) of stopping operation of a first booster pump in response to the input opening signal of the gate valve, and operation (f) of starting the stopped first booster pump at a rated speed, wherein, in operation (d), the dry pump is operating.

The method may further include operation (c) of stopping operation of the second booster pump in response to the input opening signal of the gate valve after operation (b) is performed.

In operations (c) and (d), the second booster pump and the first booster pump may be sequentially decelerated, and then the operation of the second booster pump and the first booster pump may be stopped.

In operations (c) and (d), the gate valve may be opened after the second booster pump and the first booster pump are stopped.

The method may further include operation (e) of starting the stopped second booster pump at a rated speed after operation (f) is performed.

In operations (d) and (f), the first booster pump and the second booster pump may be sequentially accelerated.

### [Advantageous Effects]

According to a vacuum pump system and a method of controlling the same according to one embodiment of the present invention, since an opening signal input to a gate valve is detected in advance while a process is performed, and booster pumps are sequentially stopped, even when the gate valve is opened, the inflow of process byproducts in a vacuum pipe, which connects a process chamber and the gate valve, into a dry pump can be minimized. In addition, since the amount of the process byproducts introduced into the dry pump is minimized, the amount of power consumed due to an overload instantaneously applied to the dry pump can be significantly reduced. Since the overload is not applied to the dry pump, the stopping of the pump due to the overload can be prevented, and thus there is an advantage of improving a process efficiency of the pump system.

Effects of the present invention are not limited to the above-described effects, and other undescribed effects may be clearly understood by those skilled in the art from the following descriptions.

### [Description of Drawings]

FIG. 1 is a block diagram illustrating a vacuum pump system according to an embodiment of the present invention.
FIG. 2 is a schematic view illustrating the vacuum pump system illustrated in FIG. 1.
FIG. 3 is a graph showing timings at which a first booster pump and a second booster pump start and stop in a state in which a dry pump operates in the vacuum pump system illustrated in FIG. 1.
FIG. 4 is a flowchart illustrating a method of controlling a vacuum pump system according to the embodiment of the vacuum pump system illustrated in FIG. 1

### [Modes of the Invention]

Hereinafter, a vacuum pump system 100 and a method S100 of controlling the same according to embodiments of the present invention will be described in detail with reference to the accompanying drawings.

In addition, components that are the same or correspond to each other regardless of reference numerals are referred to by the same or similar reference numerals and redundant descriptions thereof will be omitted, and sizes and shapes of the illustrated components may be exaggerated or reduced for convenience of description.

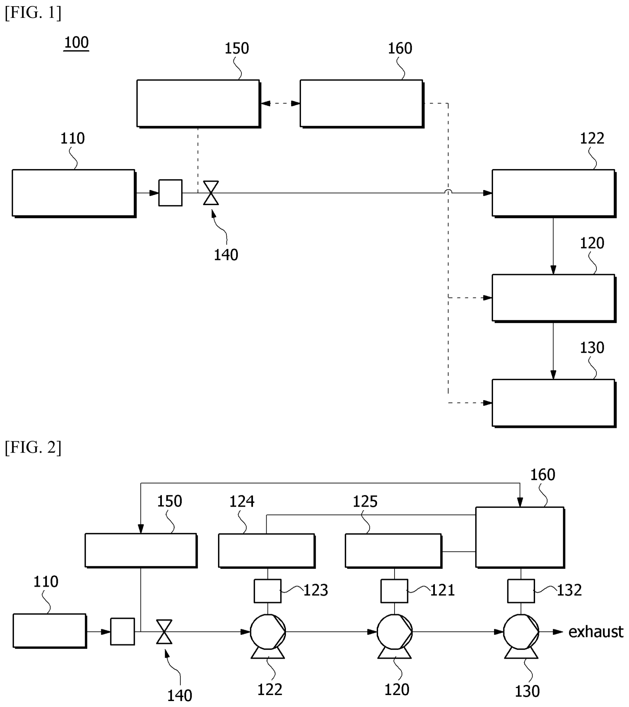

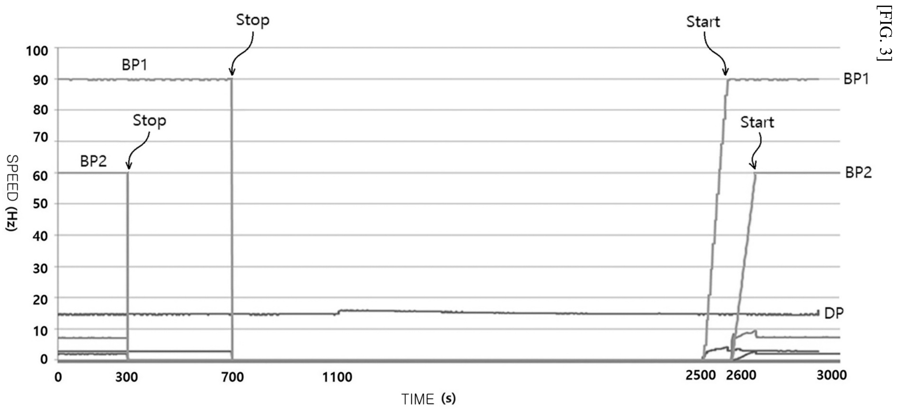

FIG. 1 is a block diagram illustrating the vacuum pump system 100 according to the embodiment of the present invention, FIG. 2 is a schematic view illustrating the vacuum pump system 100 illustrated in FIG. 1, and FIG. 3 is a graph showing timings at which a first booster pump (BP1) 120 and a second booster pump (BP2) 122 start and stop in a state in which a dry pump (DP) 130 operates in the vacuum pump system 100 illustrated in FIG. 1.

Referring to FIGS. 1 and 2, a vacuum pump system 100 according to one embodiment of the present invention may include a process chamber 110 in which a deposition process is performed, the DP 130 which is connected to the process chamber 110 to convert an atmospheric state of the process chamber 110 to a vacuum state, a BP1 120 which connects the process chamber 110 and the DP 130 and assists operation of the DP 130, a gate valve 140 provided between the process chamber 110 and the BP1 120, a valve controller 150 which controls the gate valve 140 to be opened or closed, and a pump controller 160 which is connected to the valve controller 150 and controls the DP 130 and the BP1 120 to operate according to an opening signal input to the gate valve 140 from the valve controller 150.

Although not illustrated in the drawings, the process chamber 110 may be connected to the gate valve 140 through a vacuum pipe (not shown). When the deposition process is performed, a large amount of process byproducts is accumulated in the vacuum pipe which connects the process chamber 110 and the gate valve 140.

A first motor 121 and a first inverter 124 for controlling a rotational speed of the first motor 121 may be connected to the BP1 120.

A third motor 132 may be connected to the DP 130.

Since it is not required to control a rotational speed of the DP 130 to be different from that of the BP1 120, an inverter may not be additionally connected to the DP 130.

As described above, since the BP1 120 and the DP 130 are controlled to be operated by the pump controller 160, the first motor 121, the third motor 132, and the first inverter 124 may be connected to the pump controller 160.

When the opening signal is input to the gate valve 140 from the valve controller 150, the pump controller 150 may stop the operation of the BP1 120. In this case, the DP 130 is in an operating state.

In this case, the pump controller 160 may decelerate the BP1 120 and then stop the BP1 120.

Meanwhile, the gate valve 140 may be provided not to be immediately opened even when the opening signal is input by the valve controller 150.

In other words, the gate valve 140 may be provided to be opened when a preset buffer delay time elapses after the opening signal is input from the valve controller 150. The buffer delay time preset to the gate valve 140 may be changed according to a process configuration.

When the operation of the BP1 120 is stopped by the pump controller 160, the DP 130 is continuously operating (pumping).

That is, in a state in which the DP 130 continuously operates, when the opening signal is input to the gate valve 140 from the valve controller 150, the pump controller 160 stops the BP1 120. In this case, the gate valve 140 is opened when the preset buffer delay time elapses.

Meanwhile, after the gate valve 140 is opened, the BP1 120 may be started by the pump controller 160. In this case, the BP1 120 started by the pump controller 160 may operate at a rated speed.

The rated speed of the BP1 120 may be preset, and the preset rated speed may be changed according to specifications of the BP1 120.

Meanwhile, the pump controller 160 may detect the opening signal input to the gate valve 140 from the valve controller 150 while the DP 130 operates and stop the BP1 120 to allow an amount of process byproducts in the vacuum pipe to be minimally introduced into the DP 130.

Meanwhile, referring to FIGS. 1 to 3, a vacuum pump system 100 according to another embodiment of the present invention may include a process chamber 110 in which a deposition process is performed, a DP 130 which is connected to the process chamber 110 to convert an atmospheric state of the process chamber 110 to a vacuum state, a BP1 120 and a BP2 122 which connect the process chamber 110 and the DP 130 and assist operation of the DP 130, a gate valve 140 provided between the process chamber 110 and the BP2 122, a valve controller 150 which controls the gate valve 140 to be opened or closed, and a pump controller 160 which is connected to the valve controller 150 and controls the DP 130, the BP1 120, and the BP2 122 to operate according to an opening signal input to the gate valve 140 from the valve controller 150.

Although not illustrated in the drawings, the process chamber 110 may be connected to the gate valve 140 through a vacuum pipe (not shown). When the deposition process is performed, a large amount of process byproducts is accumulated in the vacuum pipe which connects the process chamber 110 and the gate valve 140.

In this case, a first motor 121 and a second motor 123 may be connected to the BP1 120 and the BP2 122, respectively. In addition, a first inverter 124 and a second inverter 125 may be connected to the BP1 120 and the BP2 122, respectively.

A third motor 132 may be connected to the DP 130.

Since it is not required to control a rotational speed of the DP 130 to be different from those of the BP1 120 and the BP2 122, an inverter may not be additionally connected to the DP 130.

As described above, since all the BP1 120, the BP2 122, and the DP 130 are controlled by the pump controller 160, the first motor 121, the second motor 123, the third motor 132, the first inverter 124, and the second inverter 125 may be connected to the pump controller 160.

Timings at which the BP1 120 and the BP2 122 start and stop will be described with reference to FIG. 3.

In the graph of FIG. 3, an X-axis shows times [s] at which the BP1 120, the BP2 122, and the DP 130 start or stop, and a Y-axis shows speeds [Hz] of the BP1 120, the BP2 122, and the DP 130.

In this case, times at which the BP1 120 and the BP2 122 start or stop may not be limited to the times [s] shown from the graph and may be changed. In addition, rated speeds at which the BP1 120 and the BP2 122 operate may be preset, and the preset rated speeds may be changed according to specifications of the BP1 120 and the BP2 122.

When the opening signal is input to the gate valve 140 from the valve controller 150, the operation of the BP1 120 and the BP2 122 may be stopped by the pump controller 160. In this case, the DP 130 is operating.

In this case, the pump controller 160 may sequentially stop the operation of the BP2 122 and the BP1 120.

In other words, the pump controller 160 may stop the operation of the BP2 122 and then stop the operation of the BP1 120.

In addition, the pump controller 160 may sequentially decelerate the BP2 122 and the BP1 120 and then sequentially stop the BP2 122 and the BP1 120.

In other words, the pump controller 160 may decelerate the BP2 122 and then decelerate the BP1 120. After that, the pump controller 160 may completely stop the decelerated BP2 122, and then completely stop the decelerated BP1 120.

For example, the BP1 120 may be set to be stopped after the BP2 122, for which the stop signal is input from the pump controller 160, is stopped and about 400 s elapses, but is necessarily limited thereto.

In addition, the BP2 122 may be set such that a speed decreases to 0 Hz from a state in which the BP2 122 operates at a speed of 90 Hz and then the BP2 122 is stopped, and the BP1 120 may be set such that a speed of 90 Hz decreases to 0 Hz and then the BP1 120 is stopped, but the present invention is necessarily limited thereto.

Meanwhile, the gate valve 140 may be provided not to be opened immediately even when the opening signal is input by the valve controller 150.

The gate valve 140 may be preset to be opened after a buffer delay time elapses. That is, the gate valve 140 may be opened after the opening signal is input from the valve controller 150 and the preset buffer delay time elapses.

In this case, the buffer delay time preset to the gate valve 140 may be changed according to a process.

When the operation of the BP2 122 and the BP1 120 is stopped, the DP 130 is continuously operating (pumping).

That is, in a state in which the DP 130 continuously operates, when the opening signal is input to the gate valve 140 from the valve controller 150, the BP2 122 and the BP1 120 are sequentially stopped by the pump controller 160, and then the gate valve 140 is opened because the preset buffer delay time elapses.

For example, when the BP2 122 and the BP1 120 are stopped at the same time without sequentially stopping the operation of the BP2 122 and the BP1 120, since a large pressure change instantaneously occurs, a pressure load applied to the DP 130 increases, and thus a problem may occur in the DP 130. Because of this, the BP2 122 and the BP1 120 may be sequentially stopped to prevent the large pressure change from occurring such that the pressure load applied to DP 130 does not increase.

Meanwhile, after the gate valve 140 is opened, the operation of the BP1 120 and the BP2 122 may be restarted by the pump controller 160.

In addition, the pump controller 160 may sequentially start and accelerate the BP1 120 and the BP2 122 such that the BP1 120 and the BP2 reach rated speeds.

For example, it may be set such that the BP1 120, for which the start signal is input from the pump controller 160, starts first, and then the BP2 122 starts when about 100 s elapses after BP1 120 starts, but the present invention is necessarily limited thereto. In this case, the BP1 120 may be accelerated from a speed of 0 Hz to a preset rated speed of 90 Hz, and the operation thereof may be maintained, and the BP2 122 may be accelerated from a speed of 0 Hz to a preset rated speed of 60 Hz, and the operation thereof may be maintained, but the present invention is necessarily limited thereto.

As described above, the pump controller 160 may start the BP1 120 located close to the DP 130 first and then start the start the BP2 122 provided at a location farther away from the DP 130 than the BP1 120.

For example, when the BP1 120 and the BP2 122 are started at the same time, a pressure load applied to the DP 130 increases. In addition, since the BP2 122 is provided at the location farther away from the DP 130 than the BP1 120, when the BP2 122 is started first, a path resistance increases as much as a distance from the BP2 122 to the DP 130, and thus a load applied to the BP2 122 increases.

As described above, as the BP1 120 located closer to the DP 130 and the BP2 122 are sequentially started, a pressure load applied to not only the BP2 122 but also the DP 130 may be significantly reduced, and thus, the vacuum pump system 100 according to the embodiment of the present invention may be smoothly started under a condition in which a load of a pump is small.

In addition, rated capacities or the rated speeds of the BP1 120 and the BP2 122 may be provided to be different or the same, but the present invention is necessarily limited thereto.

Meanwhile, even when the rated speeds and the rated capacities of the BP1 120 and the BP2 122 are set to be different, it may be set such that operation of the BP2 122 located closer to the process chamber 110 and the BP1 120 is sequentially stopped, and conversely, the operation of the BP1 120 located closer to the DP 130 and the BP2 122 is sequentially restarted.

Meanwhile, the pump controller 160 may allow an amount of process byproducts in the vacuum pipe to be minimally introduced into the DP 130 by detecting the opening signal input to the gate valve 140 from the valve controller 150 while the DP 130 operates and stopping the BP2 122 and the BP1 120.

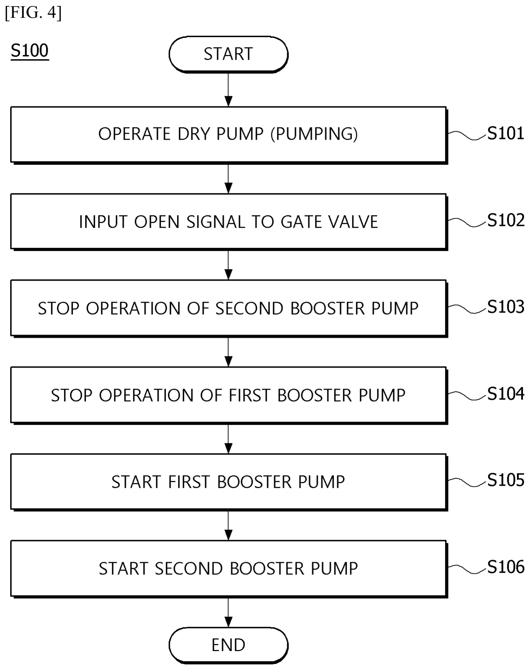

Hereinafter, the method S100 of controlling the vacuum pump system according to the embodiment of the present invention will be simply described with reference to FIG. 4.

First, the DP 130 is started using the pump controller 150 (operation a; S101).

Next, a valve opening signal is input to the gate valve 140 using the valve controller 150 (operation b; S102).

In operation b (S102), even when the opening signal is input to the gate valve 140, the gate valve 140 may be opened after a present buffer delay time elapses without being immediately opened. In this case, the buffer delay time preset to the gate valve 140 may be changed according to a process. For example, the buffer delay time may be preset such that the gate valve 140 is opened after operation of the BP1 120 and the BP2 122 is stopped.

Next, the operation of the BP2 122 is stopped using the pump controller 160 (operation c; S103).

Then, after the operation of the BP2 122 is stopped, the operation of the BP1 120 is stopped using the pump controller 160 (operation d; S104).

In operation c (S103) and operation d (S104), when the opening signal is input to the gate valve 140, the pump controller 160 may stop the operation of the BP2 122 and the BP1 120 in response to the opening signal input to the gate valve 140.

In this case, the operation of the BP2 122 and the BP1 120 may be sequentially stopped by the pump controller 160.

For example, the pump controller 160 may stop the operation of the BP1 120 after stopping the operation of the BP2 122.

In addition, the pump controller 160 may sequentially decrease rotational speeds of the BP2 122 and the BP1 120 and then stop the BP2 122 and the BP1 120.

For example, the pump controller 160 may decrease the rotational speed of the BP2 122 and then decrease the rotational speed of the BP1 120. After that, the pump controller 160 may stop the BP2 122 and stop the BP1 120.

In this case, when the BP2 122 and the BP1 120 are stopped, the DP 130 is continuously operating.

In addition, after the BP2 122 and the BP1 120 are stopped, the gate valve 140 may be in an open state because the preset buffer delay time elapses.

Next, the BP1 120 is restarted using the pump controller 160 (operation d; S105).

Next, the BP2 122 is restarted using the pump controller 160 (operation f; S106).

In operation e (S105) and operation f (S106), operation of the BP1 120 and the BP2 122 may be sequentially restarted by the pump controller 150.

In this case, in a state in which the DP 130 is operating and the gate valve 140 is opened, the pump controller 160 may start the BP1 120 and then start the BP2 122.

In addition, the pump controller 160 may sequentially accelerate the BP1 120 and the BP2 122. In this case, the pump controller 160 may accelerate the BP1 120 and the BP2 122 such that the BP1 120 and the BP2 122 reach preset rated speeds.

Finally, process byproducts introduced into the DP 130 may be discharged from the DP 130.

According to the above-described configuration, in the vacuum pump system 100 according to the embodiment of the present invention, an amount of process byproducts in the vacuum pipe which is introduced into the DP 130 can be reduced to, at minimum, about 10% to 80% of that of the conventional vacuum pump system by sequentially stopping the BP2 122 and the BP1 120 in a state in which the gate valve 140 is not opened while the DP 130, the BP1 120, and the BP2 122 operate and sequentially starting the BP1 120 and the BP2 122 after the gate valve 140 is opened.

As described above, since the amount of process byproducts introduced into the DP 130 is very small, even when the process byproducts are discharged from the DP 130, a load applied to the DP 130 can be significantly reduced, a problem that the DP 130 is stopped can be solved, and an amount of power consumed when the DP 130 operates for discharging the process byproducts can be reduced.

The above-described exemplary embodiment of the present invention is disclosed to exemplify the present invention and may be variously changed, modified, and added to by those skilled in the art within the spirit and scope of the present invention, and such changes, modifications, and additions may fall within the scope of the appended claims.

### [Industrial Applicability]

According to a vacuum pump system and a method of controlling the one embodiment of the present invention, the inflow of process byproducts into a dry pump can be minimized even when a gate valve is opened while a process is performed.

## Claims

1. A vacuum pump system comprising:
a process chamber in which a deposition process is performed;
a dry pump which is connected to the process chamber and converts an atmospheric state of the process chamber to a vacuum state;
a first booster pump which connects the process chamber and the dry pump and assists operation of the dry pump;
a gate valve provided between the process chamber and the first booster pump;
a valve controller which controls the gate valve to be opened or closed; and
a pump controller which is connected to the valve controller and controls the dry pump and the first booster pump to operate according to an opening signal input to the gate valve from the valve controller,
wherein, when the opening signal is input to the gate valve from the valve controller while the dry pump operates, the pump controller stops operation of the first booster pump.

2. The vacuum pump system of claim 1, wherein the gate valve is opened after the opening signal is input and a preset buffer delay time elapses.

3. The vacuum pump system of claim 2, wherein the pump controller stops the operation of the first booster pump during the buffer delay time of the gate valve.

4. The vacuum pump system of claim 1, wherein the gate valve is opened after the operation of the first booster pump is stopped.

5. The vacuum pump system of claim 1, further comprising a second booster pump which assists the operation of the first booster pump,
wherein the second booster pump connects the process chamber and the first booster pump, and
the second booster pump is controlled to be operated by the pump controller.

6. The vacuum pump system of claim 5, wherein one or more of a rated capacity or a rated speed of the second booster pump are provided to be different from those of the first booster pump.

7. The vacuum pump system of claim 5, wherein, when the opening signal is input to the gate valve from the valve controller, the pump controller sequentially stops the second booster pump and the first booster pump.

8. The vacuum pump system of claim 7, wherein, when the opening signal is input to the gate valve from the valve controller, the pump controller sequentially decelerates the second booster pump and the first booster pump and then stops the second booster pump and the first booster pump.

9. The vacuum pump system of claim 7, wherein the gate valve is opened after operation of the second booster pump and the first booster pump is stopped.

10. The vacuum pump system of claim 9, wherein, after the gate valve is opened, the pump controller starts the first booster pump and the second booster pump at rated speeds.

11. The vacuum pump system of claim 10, wherein the pump controller sequentially starts the first booster pump and the second booster pump.

12. The vacuum pump system of claim 10, wherein the pump controller sequentially accelerates the first booster pump and the second booster pump.

13. A method of controlling the vacuum pump system of claim 12, the method comprising;
operation (a) of starting a dry pump;
operation (b) of inputting an opening signal to a gate valve;
operation (d) of stopping operation of a first booster pump in response to the input opening signal of the gate valve; and
operation (f) of starting the stopped first booster pump at a rated speed,
wherein, in operation (d), the dry pump is operating.

14. The method of claim 13, further comprising operation (c) of stopping operation of the second booster pump in response to the input opening signal of the gate valve after operation (b) is performed.

15. The method of claim 14, wherein, in operations (c) and (d), the second booster pump and the first booster pump are sequentially decelerated, and then the operation of the second booster pump and the first booster pump is stopped.

16. The method of claim 15, wherein, in operations (c) and (d), the gate valve is opened after the second booster pump and the first booster pump are stopped.

17. The method of claim 14, further comprising operation (e) of starting the stopped second booster pump at a rated speed after operation (f) is performed.

18. The method of claim 17, wherein, in operations (d) and (f), the first booster pump and the second booster pump are sequentially accelerated.
